# EUROPEAN PATENT APPLICATION

(11) **EP 2 757 585 A2**
(43) Date of publication of application: **23.07.2014**
(21) Application number: 14001027.3
(22) Date of filing: 02.11.2012
(51) Int. Cl.: H01L 23/49, H01L 33/62, C22C 5/06

(54) **Silver bond wire for semiconductor devices**

(30) Priority: 21.11.2011 KR 20110121882
(62) Divisional of application: 12007475.2
(71) Applicant: Heraeus Materials Technology GmbH & Co. KG, 63450 Hanau (DE)
(72) Inventor: Chung, Eun-Kyun, Inchon (KR); RYU, Jae-Sung, Gyeonggi-do (KR); Tark, Yong-Deok, Incheon (KR)
(74) Representative: Brand, Normen

(57) **Abstract**

A bonding wire for semiconductor devices and a method of manufacturing the same are disclosed. The bonding wire for semiconductor devices according to the present invention includes nickel (Ni) at 5 ppm to 10 wt%, and the remainder including silver (Ag) and other inevitable impurities.

## Description

### BACKGROUND OF THE INVENTION

### (a) Field of the Invention

The present invention relates to a bonding wire and, more particularly, to a bonding wire for semiconductor devices, and a light-emitting diode (LED) package using the same, in which silver (Ag) is used as a chief ingredient.

### (b) Description of the Related Art

A bonding wire is a metal line for electrically connecting an IC chip or an LED chip and a lead frame, and is generally made of gold (Au).

In order to reduce costs when bonding wires are fabricated, because of a sudden rise of the recent worldwide gold (Au) price, attempts have been made to use copper (Cu) wires or copper (Cu) wires on which palladium (Pd) is coated for the bonding wires. Some manufacturers mass-produce the copper (Cu) wires, but continued research is being done on an alloy wire based on gold (Au) because the characteristics of copper (Cu) do not amount to those of the gold (Au).

Research is being done on a gold (Au)-silver (Ag) alloy wire as an alloy wire based on gold (Au). The gold (Au)-silver (Ag) alloy wire has an advantage in that costs can be reduced because silver (Ag) (i.e., an alloy element) having excellent electrical conductivity and gold (Au) form a complete solid solution.

However, there is a limit to the reduction of costs because a large amount of gold (Au) is contalned In the gold (Au)-silver (Ag) alloy wire. Furthermore, the copper wires and the copper wires coated with palladium (Pd) cannot be used in an LED package because reflectivity, that is, the most important function of an LED is deteriorated.

Accordingly, there is an urgent need for the development of a bonding wire made of a new material having excellent reliability and reflectivity characteristics while having a cost reduction effect.

### SUMMARY OF THE INVENTION

The present invention has been made in an effort to provide a bonding wire for semiconductor devices and an LED package using the same, in which silver (Ag) is used as a chief ingredient having an advantage of providing an alloy bonding wire that is reliable and able to replace a conventional gold (Au) alloy bonding wire. Another embodiment of the present invention provides an LED package to which a silver (Ag) alloy bonding wire capable of preventing surface discoloration inherent in a silver (Au) alloy wire and a high short ratio upon fabrication is applied. An exemplary embodiment of the present invention provides a bonding wire for semiconductor devices including nickel (Ni) at 5 ppm to 10 wt%, and the remainder including silver (Ag) and other inevitable impurities.

The bonding wire may further include at least one selected from a group consisting of copper (Cu), platinum (Pt), rhodium (Rh), osmium (Os), gold (Au), and palladium (Pd) at 0.03 wt% to 10 wt%.

The bonding wire may further include at least one selected from a group consisting of beryllium (Be), calcium (Ca), magnesium (Mg), barium (Ba), lanthanum (La), cerium (Ce), and yttrium (Y) at 3 ppm to 5 wt%.

A light emitting diode (LED) package according to another exemplary embodiment of the present invention includes an LED chip, a lead frame for supplying power to the LED chip, and a bonding wire for connecting the LED chip and the lead frame, wherein the bonding wire is the bonding wire for semiconductor devices.

A method of manufacturing a bonding wire for semiconductor devices according to another exemplary embodiment of the present invention includes the steps of: pouring a silver (Ag) alloy, including nickel (Ni) at 5 ppm to 10 wt% and a remainder including sliver (Ag) and other inevitable impurities, into a mold and melting the silver (Ag) alloy; continuously casting the melted silver (Ag) alloy; and drawing the continuously casted silver (Ag) alloy.

In the method of manufacturing a bonding wire for semiconductor devices, the silver (Ag) alloy may further include at least one selected from a group consisting of copper (Cu), platinum (Pt), rhodium (Rh), osmium (Os), gold (Au), and palladium (Pd) at 0.03 wt% to 10 wt%.

In the method of manufacturing a bonding wire for semiconductor devices, the silver (Ag) alloy may further include at least one selected from a group consisting of beryllium (Be), calcium (Ca), magnesium (Mg), barium (Ba), lanthanum (La), cerium (Ce), and yttrium (Y) at 3 ppm to 5 wt%.

The method of manufacturing a bonding wire for semiconductor devices may further include the step of performing a softening heat treatment on the drawn silver (Ag) alloy.

According to the bonding wire for semiconductor devices of the present invention as described above, a silver (Au) alloy bonding wire that uses silver (Ag) that is cheaper than gold (Au) as a chief ingredient and can provide high productivity, prevent surface discoloration, and have excellent reliability and mechanical characteristics by adding alloy atoms to silver (Ag), can be provided.

### BRIEF DESCRIPTION OF THE DRAWING

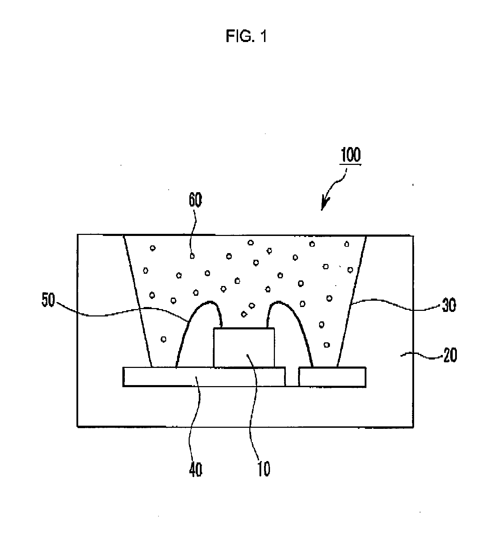

FIG. 1 is a diagram schematically showing the structure of an LED package to which a silver (Ag) alloy bonding wire according to an exemplary embodiment of the present invention is applied.

### DETAILED DESCRIPTION OF THE EMBODIMENTS

Merits and characteristics of the present invention and methods for achieving them will become more apparent from the following embodiments taken in conjunction with the accompanying drawings. However, the present invention is not limited to the disclosed embodiments, and may be implemented in various ways. The embodiments are provided to complete the disclosure of the present invention and to allow those having ordinary skill in the art to fully understand the scope of the present invention. The present invention is defined by the claims. The same reference numbers will be used throughout the drawings to refer to the same or like parts.

A bonding wire for semiconductor devices according to an exemplary embodiment of the present invention is described in detail below with reference to the accompanying drawings. For reference, in describing the present invention, a detailed description of the known functions and constructions will be omitted if it is deemed to make the gist of the present invention unnecessarily vague.

The bonding wire for semiconductor devices according to the exemplary embodiment of the present invention includes nickel (Ni) at 5 ppm to 10 wt%, and the remainder including silver (Ag) and other inevitable impurities.

The bonding wire for semiconductor devices may further include at least one selected from the group consisting of copper (Cu), platinum (Pt), rhodium (Rh), osmium (Os), gold (Au), and palladium (Pd) at 0.03 wt% to 10 wt%.

The bonding wire for semiconductor devices may further include at least one selected from the group consisting of beryllium (Be), calcium (Ca), magnesium (Mg), barium (Ba), lanthanum (La), cerium (Ce), and yttrium (Y) at 3 ppm to 5 wt%.

The silver (Ag) is a basic material forming the bonding wire according to the present invention, and it may have a degree of purity of 99.99 wt% (four-nine grade) or higher.

The silver (Ag) has excellent electrical conductivity and a face centered cubic (FCC) structure. The silver (Ag) can cause a cost reduction effect when a bonding wire is fabricated because it can replace gold (Au) that is commonly used in a conventional bonding wire.

An alloy ratio of alloy atoms of the bonding wire using silver (Ag) as a chief ingredient according to the present invention and the characteristics of the atoms are as follows.

### First group atoms

The atoms of a first group include zinc (Zn), tin (Sn), and nickel (Ni). In semiconductor devices, a silver (Ag) bonding wire or a silver (Ag) alloy bonding wire are connected to the pad of a semiconductor chip. At the time of bonding, the silver (Ag) bonding wire or the silver (Ag) alloy bonding wires may be easily discolored owing to the influence of the external environment. The atoms of the first group according to the present invention have a function of preventing the surface discoloration.

Various experiments have shown that the first group atoms have surface discoloration, low drawability, and low reliability characteristics when the first group atoms are included at less than 5 ppm, and have no surface discoloration and excellent drawability and reliability characteristics when the first group atoms are included at 0.01 to 10 wt%. Accordingly, appropriate content of the first element is 5 ppm to 10 wt%.

### Second group atoms

The second group atoms include copper (Cu), platinum (Pt), rhodium (Rh), osmium (Os), gold (Au), and palladium (Pd).

The second group atoms function to raise the tensile strength at room temperature and at a high temperature and to suppress the bending or deformation of a loop shape, such as sagging or leaning, after the loop is formed. Furthermore, the second group atoms function to improve a drawability characteristic, thereby improving productivity.

When an ultra-low loop is formed, the second group atoms function to increase tenacity by raising yield strength at a ball neck part. Accordingly, there is an effect that damage at the ball neck part is reduced or eliminated. Particularly, although a bonding wire has a small diameter, the breakage of the ball neck can be suppressed.

The copper (Cu) has the same FCC crystalline structure as the silver (Ag) and functions to improve room temperature and high temperature strength, and particularly shear strength, and to refine recrystallized structure.

Furthermore, the copper (Cu) has higher reliability at a high temperature and high humidity than rhodium (Rh) and palladium (Pd), and a small amount of copper (Cu) may ameliorate the effects of the rhodium (Rh) and palladium (Pd). If a large amount of copper (Cu) is added, however, an oxidization problem is generated and a pad is damaged because a bonding wire becomes strong.

The rhodium (Rh) and palladium (Pd) are added in order to improve the reliability and MTBA of the bonding wire. If a large amount of rhodium (Rh) and palladium (Pd) is added, resistance may be increased, a pad may be damaged because a bonding wire becomes strong, and the MTBA may be shortened.

The platinum (Pt), together with silver (Ag), forms a complete solid solution and may suppress the deterioration of adhesion strength of a compression ball and an aluminum pad.

If the second group atoms are added at less than 0.03 wt%, there is no effect. If the second group atoms are added to exceed 10 wt%, a dimple phenomenon is generated when a free air ball is formed, making it difficult to form perfect sphere. Accordingly, the appropriate content of the second group atoms is 0.03 wt% to 10 wt%.

### Third group atoms

The third group atoms include beryllium (Be), calcium (Ca), magnesium (Mg), barium (Ba), lanthanum (La), cerium (Ce), and yttrium (Y).

The third group atoms are uniformly distributed over silver (Ag) and solid-solved therein and generate an interaction of stress in lattices, thereby improving strength at room temperature. Accordingly, the third group atoms function to improve the tensile strength of the bonding wire and have an excellent effect in stabilizing a loop shape and reducing a deviation in loop height. The beryllium (Ba) and calcium (Ca) deform silver (Ag) crystal lattices through an enhanced solid solution. Accordingly, the beryllium (Ba) and calcium (Ca) can increase mechanical strength of the bonding wire, lower the recrystalline temperature of the bonding wire, and increase the height of the loop.

If the third group atoms are added at less than 3 ppm, the above effects are difficult to obtain. If the third group atoms are added to exceed 5 wt%, there is a danger that breakage may occur at a ball neck part because the tensile strength is reduced. Accordingly, appropriate content of the third group atoms is 3 ppm to 5 wt%.

The bonding wire for semiconductor devices according to the present invention may include inevitable impurities in addition to the silver (Ag) and the alloy elements. However, the impurities do not limit the scope of the present invention.

An LED package according to another exemplary embodiment of the present invention may be fabricated using the bonding wire including the first group atoms to the third group atoms.

That is, the LED package 100 according to the present invention includes an LED chip 10, a lead frame 20 for supplying power to the LED chip, and a bonding wire 50 for connecting the LED chip 10 and the lead frame 20.

More particularly, referring to FIG. 1, the LED package 100 according to the present invention includes the lead frame 20 and the LED chip 10 mounted on the bottom of a cavity 30 formed in the lead frame 20. An electrode 40 and an electrode pad on a top surface of the LED chip 10 are bonded by the bonding wire 50. A fluorescent substance 60 is coated on the inside of the cavity 30 and hardened to complete the LED package 100.

The silver (Au) alloy bonding wire using silver (Ag) as a chief ingredient according to the present invention is used as the bonding wire 50.

A method of manufacturing the bonding wire for semiconductor devices according to another exemplary embodiment of the present invention includes the steps of pouring a silver (Ag) alloy, including nickel (Ni) at 5 ppm to 10 wt% and the remainder including silver (Ag) and other inevitable impurities, into a mold and melting the silver (Ag) alloy, continuously casting a melted silver (Ag) alloy, and then drawing the continuously casted silver (Ag) alloy.

The silver (Ag) alloy further includes at least one selected from the group consisting of copper (Cu), platinum (Pt), rhodium (Rh), osmium (Os), gold (Au), and palladium (Pd) at 0.03 wt% to 10 wt%.

The silver (Ag) alloy further includes at least one selected from the group consisting of beryllium (Be), calcium (Ca), magnesium (Mg), barium (Ba), lanthanum (La), cerium (Ce), and yttrium (Y) at 3 ppm to 5 wt%.

The method of manufacturing the bonding wire for semiconductor devices further includes the step of performing a softening heat treatment on the drawn silver (Ag) alloy.

The present invention is described in more detail with reference to the method of manufacturing the bonding wire according to the present invention and the evaluation results of physical properties of the manufactured bonding wire.

### <Method of manufacturing the silver (Ag) alloy bonding wire>

The silver (Ag) alloy, including zinc (Zn) (i.e., the first group atoms) at 0.01 wt%, gold (Au) (i.e., the second group atoms) at 0.5 wt%, palladium (Pd) (i.e., the second group atoms) at 0.5 wt%. calcium (Ca) (i.e., the third group atoms) at 0.005 wt%, and the remainder including silver (Ag) and other inevitable impurities, was poured into a mold and then melted.

The melted silver (Ag) alloy was continuously casted, drawn, and then subjected to a softening heat treatment in order to soften the bonding wire that is hardened by the drawing.

In a pressure chamber test used in order to evaluate reliability of the bonding wire in the present invention, chamber conditions included a temperature of 85°C, a pressure of 2 atmospheres, relative humidity of 85%, and 5 V for 504 hours or more.

In the conditions, after the bonding wire materials were kept and then evaluated by performing a ball pull test (BPT). At the time of the BPT, a criterion for determining lift was that breakage was not generated at a ball neck and a ball adhesion part was lifted from the pad.

As a result of the test, when the ball lift rate was 0%, it was evaluated as being excellent. When the ball lift rate was higher than 0% to 2% or less, it was evaluated as being good, when the ball lift rate was higher than 2% to 5% or less, it was evaluated as being average, and when the ball lift rate was higher than 5%, it was evaluated as being defective.

Table 1 shows content of the components of the bonding wire according to the present invention.

In Table 1 below, No. 1 to No. 71 show experimental examples of the bonding wires manufactured according to the present invention, and content of the components of each bonding wire is shown in the table. The unit of content of each component is weight percent, and content of silver (Ag) refers to the remaining balance (Bal).

**[Table 1]**

| No | Ag | Zn | Sn | Ni | Cu | Pt | Rh | Os | Au | Pd | Be | Ca | Mg | Ba | La | Ce | Y |
|---|---|---|---|---|---|---|---|---|---|---|---|---|---|---|---|---|---|
| 1 | Ba l. | 0.001 | - | - | - | | | | | | | | | | | | |
| 2 | Ba l. | 0.01 | | | | | | | | | | | | | | | |
| 3 | Ba l. | 0.05 | | | | | | | | | | | | | | | |
| 4 | Ba l. | 0.10 | | | | | | | | | | | | | | | |
| 5 | Ba l. | 0.50 | | | | | | | | | | | | | | | |
| 6 | Ba l. | 1.00 | | | | | | | | | | | | | | | |
| 7 | Ba l. | 5.00 | | | | | | | | | | | | | | | |
| 8 | Ba l. | 10.00 | | | | | | | | | | | | | | | |
| 9 | Ba l. | | 0.001 | | | | | | | | | | | | | | |
| 10 | Ba l. | | 0.01 | | | | | | | | | | | | | | |
| 11 | Ba l. | | 0.05 | | | | | | | | | | | | | | |
| 12 | Ba l. | | 0.10 | | | | | | | | | | | | | | |
| 13 | Ba l. | | 0.50 | | | | | | | | | | | | | | |
| 14 | Ba l. | | 1.00 | | | | | | | | | | | | | | |
| 15 | Ba l. | | 5.00 | | | | | | | | | | | | | | |
| 16 | Ba l. | | 10.00 | | | | | | | | | | | | | | |
| 17 | Ba l. | | | 0.001 | | | | | | | | | | | | | |
| 18 | Ba l. | | | 0.01 | | | | | | | | | | | | | |
| 19 | Ba l. | | | 0.05 | | | | | | | | | | | | | |
| 20 | Ba l. | | | 0.10 | | | | | | | | | | | | | |
| 21 | Ba l. | | | 0.50 | | | | | | | | | | | | | |
| 22 | Ba l. | | | 1.00 | | | | | | | | | | | | | |
| 23 | Ba l. | | | 5.00 | | | | | | | | | | | | | |
| 24 | Ba l. | | | 10.00 | | | | | | | | | | | | | |
| 25 | Ba l. | | | | 0.03 | | | | | | | | | | | | |
| 26 | Ba l. | | | | 0.05 | | | | | | | | | | | | |
| 27 | Ba l. | | | | 0.1 | | | | | | | | | | | | |
| 28 | Ba l. | | | | 0.5 | | | | | | | | | | | | |
| 29 | Ba l. | | | | 1 | | | | | | | | | | | | |
| 30 | Ba l. | | | | 5 | | | | | | | | | | | | |
| 31 | Ba l. | | | | 10 | | | | | | | | | | | | |
| 32 | Ba l. | | | | | 0.1 | | | | | | | | | | | |
| 33 | Ba l. | | | | | 1 | | | | | | | | | | | |
| 34 | Ba l. | | | | | | 1 | | | | | | | | | | |
| 35 | Ba l. | | | | | | | 1 | | | | | | | | | |
| 36 | Ba l. | | | | | | | | 0.5 | | | | | | | | |
| 37 | Ba l. | | | | | | | | 1 | | | | | | | | |
| 38 | Ba l. | | | | | | | | 5 | | | | | | | | |
| 39 | Ba l. | | | | | | | | | 0.01 | | | | | | | |
| 40 | Ba l. | | | | | | | | | 0.05 | | | | | | | |
| 41 | Ba l. | | | | | | | | | 0.1 | | | | | | | |
| 42 | Ba l. | | | | | | | | | 0.5 | | | | | | | |
| 43 | Ba l. | | | | | | | | | 1 | | | | | | | |
| 44 | Ba l. | | | | | | | | | 5 | | | | | | | |
| 45 | Ba l. | | | | | | | | | 10 | | | | | | | |
| 46 | Ba l. | | | | | | | | | | 0.001 | | | | | | |
| 47 | Ba l. | | | | | | | | | | | 0.001 | | | | | |
| 48 | Ba l. | | | | | | | | | | | 0.005 | | | | | |
| 49 | Ba l. | | | | | | | | | | | 0.01 | | | | | |
| 50 | Ba l. | | | | | | | | | | | 0.05 | | | | | |
| 51 | Ba l. | | | | | | | | | | | | 0.001 | | | | |
| 52 | Ba l. | | | | | | | | | | | | | 0.001 | | | |
| 53 | Ba l. | | | | | | | | | | | | | | 0.001 | | |
| 54 | Ba l. | | | | | | | | | | | | | | | 0.001 | |
| 55 | Ba l. | | | | | | | | | | | | | | | | 0.001 |
| 56 | Ba l. | 0.01 | | | 0.03 | | | | | | | | | | | | |
| 57 | Ba l. | 0.05 | | | 0.05 | | | | | | | | | | | | |
| 58 | Ba l. | 0.10 | | | 0.1 | | | | | | | | | | | | |
| 59 | Ba l. | 0.50 | | | 0.5 | | | | | | | | | | | | |
| 60 | Ba l. | 1.00 | | | 1 | | | | | | | | | | | | |
| 61 | Ba l. | | 0.05 | | | | | | 0.5 | | | | | | | | |
| 62 | Ba l. | | 0.10 | | | | | | 1 | | | | | | | | |
| 63 | Ba l. | | 0.50 | | | | | | 5 | | | | | | | | |
| 64 | Ba l. | | 1.00 | | | | | | 10 | | | | | | | | |
| 65 | Ba l. | | | 0.05 | | | | | | 0.05 | | | | | | | |
| 66 | Ba l. | | | 0.10 | | | | | | 0.1 | | | | | | | |
| 67 | Ba l. | | | 0.50 | | | | | | 0.5 | | | | | | | |
| 68 | Ba I. | | | 1.00 | | | | | | 1 | | | | | | | |
| 69 | Ba I. | 0.01 | | | | | | | 0.5 | 0.5 | | 0.005 | | | | | |
| 70 | Ba I. | | | 0.01 | | | | | 5 | 1 | | | | | | | 0.01 |
| 71 | Ba I. | | 0.1 | | 0.0 3 | | | | 0.5 | 0.5 | | | | | | 0.01 | |

In Table 1, Experimental Examples 1 to 8 show bonding wires manufactured by changing the zinc (Zn) (i.e., the first group atoms) content, Experimental Examples 9 to 16 show bonding wires manufactured by changing tin (Sn) (i.e., the first group atoms) content, and Experimental Examples 17 to 24 show bonding wires manufactured by changing nickel (Ni).

Furthermore, Experimental Examples 25 to 31 show bonding wires manufactured by changing copper (Cu) (i.e., the second group atoms) content, Experimental Examples 32 and 33 show bonding wires manufactured by changing platinum (Pt) (i.e., the second group atoms) content, Experimental Examples 34 and 35 show bonding wires manufactured by adding rhodium (Rh) and osmium (Os) (i.e., the second group atoms), respectively, Experimental Examples 36 to 38 show bonding wires manufactured by changing gold (Au) (i.e., the second group atoms) content, and Experimental Examples 39 to 46 show bonding wires manufactured by changing palladium (Pd) (i.e., the second group atoms) content.

Experimental Example 46 show a bonding wire manufactured by adding beryllium (Be) (i.e., the third group atoms), Experimental Examples 47 to 50 show bonding wires manufactured by changing calcium (Ca) (i.e., the third group atoms) content, and Experimental Examples 51 to 55 show bonding wires manufactured by adding magnesium (Mg), barium (Ba), lanthanum (La), cerium (Ce), and yttrium (Y) (i.e., the third group atoms), respectively.

Experimental Examples 56 to 60 show bonding wires manufactured by changing zinc (Zn) (i.e., the first group atoms) content and copper (Cu) (i.e., second group atoms) content, Experimental Examples 61 to 64 show bonding wires manufactured by changing tin (Sn) (i.e., the first group atoms) content and gold (Au) (i.e., the second group atoms) content, and Experimental Examples 65 to 68 show bonding wires manufactured by changing nickel (Ni) (i.e., the first group atoms) content and palladium (Pd) (i.e., the second group atoms) content.

Experimental Example 69 shows a bonding wire including zinc (Zn) (i.e., the first group atoms) content, gold (Au) and palladium (Pd) (i.e., the second group atoms), and calcium (Ca) (i.e., the third group atoms). Experimental Example 70 shows a bonding wire including nickel (Ni) (i.e., the first group atoms), gold (Au) and palladium (Pd) (i.e., the second group atoms), and yttrium (Y) (i.e., the third group atoms). Experimental Example 71 shows a bonding wire including tin (Sn) (i.e., the first group atoms), copper (Cu), gold (Au), and palladium (Pd) (i.e., the second group atoms), and cerium (Ce) (i.e., the third group atoms).

Table 2 below shows the evaluation results of physical characteristics of the bonding wires according to the present invention shown in Table 1.

**[Table 2]**

| No. | Surfac e discoloration | FAB | Ball pull test | | | Tensile strength | Resistivity | Drawability | Hardness | Shelf life |
|---|---|---|---|---|---|---|---|---|---|---|
| | | shape | Before PCT | After PCT | Reliability | (g) | (µΩcm) | | (Hv) | (day) |
| 1 | Δ | Δ | 7.5 | 1.8 | X | 13.5 | 1.7 | 1.6 | 63 | 32 |
| 2 | ⊚ | Δ | 9 | 2 | X | 13.8 | 1.7 | 0.06 | 64 | 256 |
| 3 | ⊚ | Δ | 9.5 | 8.4 | ⊚ | 14 | 1.7 | 0.06 | 64 | 256 |
| 4 | ⊚ | Δ | 9.6 | 9.2 | ⊚ | 14.5 | 1.8 | 0.05 | 65 | 256 |
| 5 | ⊚ | Δ | 97 | 9.4 | ⊚ | 15.7 | 2.2 | 0.05 | 65 | 256 |
| 6 | ⊚ | Δ | 102 | 9.5 | ⊚ | 18 | 2.8 | 0.05 | 66 | 256 |
| 7 | Δ | x | 12.5 | 8.4 | Δ | 23 | 4.7 | 16 | 80 | 32 |
| 8 | Δ | X | 12.9 | 8.3 | Δ | 28 | 5 | 1.6 | 90 | 32 |
| 9 | Δ | Δ | 7 | 1.5 | X | 12 | 1.7 | 16 | 63 | 32 |
| 10 | ⊚ | A | 8.2 | 1.9 | X | 12.5 | 1.7 | 0.06 | 64 | 256 |
| 11 | ⊚ | Δ | 9.2 | 82 | ⊚ | 13 | 1.7 | 0.06 | 64 | 256 |
| 12 | ⊚ | Δ | 10 | 9.1 | ⊚ | 14 | 18 | 0.05 | 65 | 256 |
| 13 | ⊚ | Δ | 10.3 | 9.3 | ⊚ | 15 | 2.2 | 0.05 | 65 | 256 |
| 14 | ⊚ | Δ | 10.6 | 9.4 | ⊚ | 17 | 2.8 | 0.05 | 66 | 256 |
| 15 | Δ | X | 11.1 | 8.5 | A | 21 | 4.7 | 1.6 | 74 | 32 |
| 16 | Δ | X | 11.6 | 8.2 | Δ | 26 | 5 | 1.6 | 74 | 32 |
| 17 | Δ | A | 8 | 2 | x | 14.3 | 1.7 | 1.32 | 63 | 32 |
| 18 | ⊚ | Δ | 9.5 | 2.1 | X | 14.5 | 1 7 | 0.25 | 64 | 256 |
| 19 | ⊚ | Δ | 10 | 8.5 | ⊚ | 15 | 1.7 | 0.25 | 64 | 256 |
| 20 | ⊚ | Δ | 11.3 | 95 | ⊚ | 17.2 | 1.8 | 0.25 | 64 | 256 |
| 21 | ⊚ | Δ | 11.7 | 9.5 | ⊚ | 17.5 | 22 | 0.3 | 64 | 256 |
| 22 | ⊚ | Δ | 12.3 | 9.6 | ⊚ | 18 | 2.8 | 0.3 | 64 | 256 |
| 23 | Δ | X | 13.4 | 8.5 | Δ | 26 | 4.7 | 1.32 | 66 | 256 |
| 24 | Δ | X | 14.8 | 8.4 | Δ | 30 | 5 | 1.6 | 74 | 256 |
| 25 | ⊚ | Δ | 10.3 | 1.4 | X | 14 | 1.7 | 2 | 63 | 32 |
| 26 | ⊚ | Δ | 10.5 | 15 | X | 14.3 | 1.7 | 1.68 | 63 | 32 |
| 27 | ⊚ | Δ | 11.2 | 2.6 | X | 15.3 | 1.7 | 0.03 | 65 | 128 |
| 28 | ⊚ | Δ | 112 | 2.6 | X | 15.3 | 1.7 | 0.03 | 66 | 128 |
| 29 | X | X | 11.3 | 2.6 | X | 15.5 | 1.7 | 0.03 | 66 | 128 |
| 30 | X | X | 12.1 | 2.4 | Δ | 21 | 4.3 | 0.04 | 67 | 128 |
| 31 | X | X | 13.5 | 2.4 | Δ | 27 | 10.5 | 0.06 | 74 | 128 |
| 32 | ⊚ | Δ | 11.4 | 2.8 | ⊚ | 15 | 1.7 | 1.1 | 65 | 32 |
| 33 | ⊚ | Δ | 12 | 2.7 | ⊚ | 16 | 2.5 | 0.9 | 66 | 32 |
| 34 | ⊚ | Δ | 10.9 | 2.4 | ⊚ | 14 | 2.5 | 1.5 | 66 | 32 |
| 35 | ⊚ | Δ | 10.5 | 2.3 | ⊚ | 15 | 2.5 | 1.5 | 67 | 32 |
| 36 | ⊚ | Δ | 10.3 | 9.3 | ⊚ | 14 | 1.7 | 1.9 | 64 | 32 |
| 37 | ⊚ | Δ | 11 | 9.8 | ⊚ | 15 | 1.7 | 1.9 | 65 | 256 |
| 38 | ⊚ | Δ | 11.9 | 10.7 | ⊚ | 17 | 3 | 2 | 67 | 256 |
| 39 | ⊚ | Δ | 10.5 | 1.5 | X | 14.3 | 1.7 | 1.51 | 63 | 32 |
| 40 | ⊚ | Δ | 10.7 | 9.5 | ⊚ | 16.2 | 1.8 | 0.13 | 64 | 128 |
| 41 | ⊚ | Δ | 108 | 9.8 | ⊚ | 17 | 1.8 | 0.1 | 64 | 256 |
| 42 | ⊚ | Δ | 11 | 10 | ⊚ | 17.3 | 2 | 0.1 | 64 | 256 |
| 43 | ○ | Δ | 11.2 | 10.2 | ⊚ | 17.5 | 2.9 | 0.09 | 65 | 256 |
| 44 | ○ | Δ | 12 | 10.9 | ⊚ | 21 | 4.5 | 0.1 | 66 | 256 |
| 45 | Δ | Δ | 12.4 | 6.3 | ○ | 27.5 | 10.8 | 1.56 | 70 | 256 |
| 46 | ⊚ | Δ | 8 | 1.4 | ⊚ | 13 | 1.7 | 2.2 | 63 | 32 |
| 47 | ⊚ | Δ | 12.4 | 2.2 | X | 16 | 1.7 | 0.04 | 64 | 32 |
| 48 | ⊚ | Δ | 12.6 | 2.1 | X | 17.8 | 1.7 | 004 | 65 | 128 |
| 49 | ⊚ | Δ | 12.9 | 1.9 | X | 18.1 | 1.7 | 0.07 | 66 | 128 |
| 50 | ⊚ | Δ | 12.9 | 1.5 | X | 18.2 | 1.8 | 1.74 | 71 | 128 |
| 51 | ⊚ | Δ | 9 | 1.5 | X | 15 | 1.7 | 2 | 63 | 32 |
| 52 | ⊚ | Δ | 8.2 | 1.3 | X | 13 | 1.7 | 3 | 63 | 32 |
| 53 | ⊚ | A | 10 | 1.6 | X | 14 | 1.7 | 1.7 | 63 | 32 |
| 54 | ⊚ | Δ | 8.8 | 1.5 | X | 15 | 1.7 | 2.4 | 63 | 32 |
| 55 | ⊚ | Δ | 8.5 | 14 | X | 16 | 1.7 | 1 | 63 | 32 |
| 56 | ⊚ | Δ | 10.3 | 1.3 | X | 14 | 1.7 | 2 | 63 | 32 |
| 57 | ⊚ | Δ | 10.5 | 1.6 | X | 14.3 | 1.7 | 1.68 | 63 | 128 |
| 58 | ⊚ | Δ | 11.2 | 27 | X | 15.3 | 1.7 | 0.03 | 65 | 128 |
| 59 | ⊚ | Δ | 11.2 | 2.7 | X | 15.3 | 1.7 | 0.03 | 66 | 128 |
| 60 | ○ | Δ | 11.3 | 2.7 | X | 15.5 | 1.9 | 0.03 | 66 | 128 |
| 61 | ⊚ | Δ | 10.3 | 9.3 | ⊚ | 14 | 1.7 | 1.9 | 65 | 32 |
| 62 | ⊚ | Δ | 11 | 9.8 | ⊚ | 15 | 1.7 | 1.9 | 66 | 256 |
| 63 | ⊚ | Δ | 11.9 | 10.7 | ⊚ | 17 | 3 | 2 | 68 | 256 |
| 64 | ⊚ | Δ | 13 | 12 | ⊚ | 21 | 4.7 | 3 | 72 | 256 |
| 65 | ⊚ | Δ | 10.9 | 9.6 | ⊚ | 16.7 | 1.7 | 0.12 | 64 | 128 |
| 66 | ⊚ | Δ | 11 | 99 | ⊚ | 172 | 1.7 | 0.17 | 64 | 256 |
| 67 | ⊚ | Δ | 11.3 | 10.2 | ⊚ | 17.8 | 2 | 0.19 | 67 | 256 |
| 68 | ○ | Δ | 11.6 | 10.5 | ⊚ | 18.5 | 2.9 | 0.2 | 69 | 256 |
| 69 | ⊚ | Δ | 10.7 | 9.6 | ⊚ | 15.2 | 1.8 | 2.3 | 65 | 128 |
| 70 | ⊚ | Δ | 11.2 | 10.2 | ⊚ | 15.9 | 3 | 1.9 | 67 | 256 |
| 71 | ⊚ | Δ | 10.8 | 9.8 | ⊚ | 15.4 | 1.8 | 2.2 | 66 | 128 |

In Table 2, surface discoloration is the result measured based on the reflectivity of the wire, wherein ⊚ indicated an excellent state, ○ is a good state, Δ is a normal state, and X is a bad state.

FAB is an abbreviation of a free air ball. A circular FAB for performing ball bonding can be formed at the wire tail at the capillary tip by using EFO discharge after secondary bonding. Here, regarding the formed FAB shape, perfect sphere is indicated by an excellent state. A case where the formed FAB shape has perfect sphere but it is slightly deviated from the center of the wire is indicated by a quite excellent state. A case where the formed FAB shape is slightly deviated from perfect sphere and the center of the wire is indicated by a normal state. A case where a tilted ball (a FAB severely deviated from the center of the wire) and bonding are not possible for the formed FAB shape is indicated by a bad state.

A FAB shape characteristic is also indicated by the same meaning as the marks of the surface discoloration

High humidity reliability is indicated by adhesion strength (a BPT value) in a pressure cooker test (PCT).

The silver (Ag) alloy wire had a diameter of 30 µm, and the PCT was performed at 121°C for about 96 hours.

In reliability of adhesion strength, ⊚ indicates an excellent state, ○ indicates a quite excellent state, Δ indicates a normal state, and X indicates a bad state.

Processability was measured by the number of disconnected wires per 1 km of the silver (Ag) alloy wire. Processability has a better characteristic according to a reduction in the value.

In a shelf life test, the time that it took for a 100 nm thick oxide layer to be formed in the silver (Ag) alloy wire was indicated by a date. The shelf life test has a better characteristic according to an increase in the value.

From Tables 1 to 2, it can be seen that zinc (Zn), tin (Sn), and nickel (Ni) content (i.e., the first addition components) influences the surface discoloration of the silver (Ag) alloy wire in Experimental Examples 1 to 24.

It can be seen that in Experimental Examples 1 to 24, the silver (Ag) alloy wire has excellent surface discoloration, drawability, and reliability in zinc (Zn), tin (Sn), and nickel (Ni) content at 0.01 to 10 wt%, and the FAB shape characteristic is influenced with zinc (Zn), tin (Sn), and nickel (Ni) content of 5 wt% or higher.

It can be seen that in Experimental Examples 25 to 31, copper (Cu) content (i.e., the second group components) influences the surface discoloration of the silver (Ag) alloy wire. When the copper (Cu) content is less than 1%, the surface discoloration of the silver (Ag) alloy wire has an excellent characteristic. When the copper (Cu) content is 0.1% or higher, an excellent processability characteristic starts to show.

On the other hand, it can be seen that the reliability and FAB shape of the silver (Ag) alloy wire are adversely affected.

It can be seen that in Experimental Examples 36 to 45, gold (Au) and palladium (Pd) content (i.e., the second group components) have an excellent effect on the reliability, and surface discoloration of the silver (Ag) alloy wire with the palladium (Pd) content has a better characteristic in terms of processability.

In Experimental Examples 51 to 55, magnesium (Mg), barium (Ba), lanthanum (La), cerium (Ce), and yttrium (Y) (i.e., the third group components) reveal adhesion strength and drawing characteristics of the silver (Ag) alloy wire.

In Experimental Examples 56 to 60, the characteristics of an alloy including zinc (Zn) and copper (Cu) can be known. It can be seen that adhesion strength is increased and the drawing characteristic becomes better according to an increase of zinc (Zn) and copper (Cu) content.

In Experimental Examples 61 to 64, the characteristic of an alloy including tin (Sn) and gold (Au) can be known. It can be seen that a drawing characteristic is excellent according to a decrease of tin (Sn) and gold (Au) content, and adhesion strength and shelf life are increased according to an increase of tin (Sn) and gold (Au).

In Experimental Examples 65 to 68, the characteristics of an alloy including nickel (Ni) and palladium (Pd) can be known. It can be seen that strength is improved according to an increase of nickel (Ni) and palladium (Pd) content, and the drawing characteristic and strength of palladium (Pd) are improved.

In Experimental Examples 69 to 71, the characteristics of a silver (Ag) alloy wire made of a ternary alloy or more including gold (Au) and palladium (Pd) can be known. If the gold (Au) and palladium (Pd) content are increased, adhesion strength and the drawing characteristic become excellent, but the electrical characteristic tends to be decreased. If gold (Au) and palladium (Pd) are included, reliability is excellent characteristic and there is an excellent characteristic that the shelf life is increased.

Although the present invention has been described on the basis of the exemplary embodiments of the present invention, a person having ordinary skill in the art to which the present invention pertains will understand that the present invention may be implemented in various ways without departing from the technical spirit or the essential characteristics of the present invention.

Therefore, it will be understood that the above-described embodiments are illustrative and not limitative from all aspects. The scope of the present invention is defined by the appended claims rather than the detailed description, and the present invention should be construed to cover all modifications or variations induced from the meaning and scope of the appended claims and their equivalents.

**<Description of Symbols>**

| | |
|---|---|
| 10: LED chip | 20: lead frame |
| 30: cavity | 40: electrode |
| 50: bonding wire | 60: fluorescent substance |
| 100: LED package | |

## Claims

1. A bonding wire for semiconductor devices, comprising:
nickel (Ni) at 5 ppm to 10 wt%; and
a remainder including silver (Ag) and other inevitable impurities.

2. The bonding wire of claim 1, further comprising at least one selected from a group consisting of copper (Cu), platinum (Pt), rhodium (Rh), osmium (Os), gold (Au), and palladium (Pd) at 0.03 wt% to 10 wt%.

3. The bonding wire of claim 1 or claim 2, further comprising at least one selected from a group consisting of beryllium (Be), calcium (Ca), magnesium (Mg), barium (Ba), lanthanum (La), cerium (Ce), and yttrium (Y) at 3 ppm to 5 wt%.

4. A light emitting diode (LED) package comprising an LED chip, a lead frame for supplying power to the LED chip, and a bonding wire for connecting the LED chip and the lead frame, wherein the bonding wire is a bonding wire for semiconductor devices according to any one of claims 1 to 3.

5. A method of manufacturing a bonding wire for semiconductor devices, comprising the steps of:
pouring a silver (Ag) alloy, including nickel (Ni) at 5 ppm to 10 wt% and a remainder including silver (Ag) and other inevitable impurities, into a mold and melting the silver (Ag) alloy;
continuously casting the melted silver (Ag) alloy; and
drawing the continuously casted silver (Ag) alloy.

6. The method of claim 5, wherein the silver (Ag) alloy further comprises at least one selected from a group consisting of copper (Cu), platinum (Pt), rhodium (Rh), osmium (Os), gold (Au), and palladium (Pd) at 0.03 wt% to 10 wt%.

7. The method of claim 5 or 6, wherein the silver (Ag) alloy further comprises at least one selected from a group consisting of beryllium (Be), calcium (Ca), magnesium (Mg), barium (Ba), lanthanum (La), cerium (Ce), and yttrium (Y) at 3 ppm to 5 wt%.

8. The method of claim 7, further comprising the step of performing a softening heat treatment on the drawn silver (Ag) alloy.
